Europäisches Patentamt

European Patent Office

Office européen des brevets

(11) Numéro de publication: **0 068 058**
**B1**

(12) **FASCICULE DE BREVET EUROPEEN**

(45) Date de publication du fascicule du brevet: **03.09.86**

(21) Numéro de dépôt: **81430019.0**

(22) Date de dépôt: **25.06.81**

(51) Int. Cl.⁴: **G 11 C 17/00**

(54) **Mémoire morte électriquement programmable.**

(43) Date de publication de la demande:
**05.01.83 Bulletin 83/01**

(45) Mention de la délivrance du brevet:
**03.09.86 Bulletin 86/36**

(84) Etats contractants désignés:
**DE FR GB**

(56) Documents cités:
**FR-A-2 300 397**
**FR-A-2 471 024**
**US-A-3 576 549**
**US-A-3 787 822**
**US-A-4 174 521**
**IBM TECHNICAL DISCLOSURE BULLETIN, vol. 15, no. 3, aou7t 1972, New York, US, HERRELL et al.: "Write once read-only store", pages 949-950**

**IBM TECHNICAL DISCLOSURE BULLETIN, vol. 13, no. 6, novembre 1970, New York, US, ABBAS: "Electronically encodable read-only store", pages 1426-1427**

**EXTENDED ABSTRACTS, vol. 77, no. 2, octobre 1977, Princeton, US, SEAWARD et al.: "Uniformity of oxygen-doped polysilicon films", pages 948-950**

(73) Titulaire: **International Business Machines Corporation**
**Old Orchard Road**
**Armonk, N.Y. 10504 (US)**

(72) Inventeur: **Basire, Dominique**
**35 rue des Prés**
**F-77960 Chailly-en-Bière (FR)**
Inventeur: **Bhattacharyya, Arup**
**18 Glenwood Drive Essex Junction**
**Vermont, 05452 Chittenden (US)**
Inventeur: **Howard, James**
**Cedar Hill Road**
**Fishkill N.Y. 12524 (US)**
Inventeur: **Mollier, Pierre**
**15 rue de Ponthierry F-77310 Boissise-le-Roi**
**Saint Fargeau Ponthierry (FR)**

(74) Mandataire: **Lattard, Nicole**
**Compagnie IBM France Département de Propriété Industrielle**
**F-06610 La Gaude (FR)**

Courier Press, Leamington Spa, England.

Ⓜ️ Documents cités:

**CHEMICAL ABSTRACTS, vol. 86, no. 8, 21 février 1977, ref. 49598r, page 415, Columbus, Ohio, US, J.K. PARK et al.: "Thin ferroelectric films of barium titanate on doped silicon"**

**Description**

Domaine Technique

La présente invention concerne une mémoire morte rapide de densité élevée et pouvant être programmée électriquement.

Les mémoires mortes sont des éléments largement utilisés pour la réalisation de nombreux systèmes électroniques, par exemple pour contenir les mots de commande contrôlant l'exécution des instructions d'un programme dans une unité de contrôle ou un microprocesseur, pour réaliser les matrices ET et OU de réseaux logiques proprammables, et généralement pour constituer des tables dans lesquels sont stockées des informations qui ne doivent qu'être lues. Il faut donc que ces éléments présentent une vitesse de fonctionnement la plus élevée possible comparable à celle des mémoires à accès aléatoire RAM. De plus l'opération de programmation de ces mémoires mortes, nécessaire pour stocker l'information qu'elles doivent contenir doit être la plus aisée possible.

Art antérieur

Actuellement il existe différents types de mémoires mortes. Celles qui peuvent être programmées électriquement sont généralement du type à transistors C MOS à porte flottante tel que décrit dans l'article paru dans Electronics du 6 juillet 1978 à la page 107. En conséquence, elles ne présentent pas les caractéristiques de vitesse optimum.

Les mémoires mortes qui présentent de bonnes caractéristiques de vitesse sont réalisées par une matrice de cellules de mémoire chacune comportant un transistor bipolaire avec une résistance fusible connectée à l'émetteur, résistance que l'on fait fondre ou non par passage d'un courant adéquat ou autre moyen approprié, pour mettre la cellule dans l'un ou l'autre état représentant un "1" ou "0" binaire. De telles mémoires sont décrites dans l'article "Bipolar PROM Reliability" paru dans Microelectronics Reliability, Vol. 18, pages 325 à 332, Pergamon Press 1978, et dans le brevet français FR A 2 300 397. Dans ce dernier brevet, des circuits séparés sont utilisés pour effectuer la lecture et la programmation.

Dans ce type de mémoire la résistance fusible occupe beaucoup de place et en conséquence, la densité d'intégration obtenue n'est pas suffisante.

Pour atteindre des densités élevées, ainsi que décrit dans le brevet français FR A 2 471 024, on réalise des mémoires mortes dans lesquelles chaque cellule ne comporte qu'un transistor bipolaire. Ces mémoires mortes sont personnalisées au cours d'une étape de fabrication et c'est la présence ou l'absence d'une ouverture à l'émetteur qui indique que la cellule contient un "un" ou un "zéro". En conséquence dans une telle mémoire les transistors TL1—TLm qui correspondent aux transistors 19 de notre demande ne sont utilisés que pour la lecture. Ce type de mémoire présente les caractéristiques de vitesse élevée et de densité d'intégration élevée mais elles ne peuvent être personnalisées directement par l'utilisateur.

Le brevet US A 3 576 549 décrit une mémoire programmable, dans laquelle les cellules sont constituées de dispositifs semiconducteurs dans laquelle une couche isolante recouvre toute la surface de la mémoire, et est utilisée à la fois comme couche isolante classique et comme moyen pour faire ou non la connexion à une électrode du dispositif semiconducteur. Pour cela, la couche isolante est claquée dans les cellules sélectionnées. Cet arrangement a comme inconvénients de nécessiter des tensions de claquage élevées, du fait de l'épaisseur de la couche, et de n'être pas fiable car, la couche étant continue, des claquages parasites peuvent se produire.

Pour réaliser des mémoires mortes on ne peut pas utiliser les cellules constituant généralement les mémoires à accès aléatoire du type dynamique telles que décrites dans les brevets US A 3 979 734 et 3 876 994 dans lesquelles l'information binaire 1 ou 0 est représentée par la quantité de charges d'une capacité connectée à l'émetteur d'un transistor bipolaire, car ces cellules ont besoin d'être rafraîchies.

Résumé de la présente invention

Un objet de la présente invention est de réaliser une mémoire morte électriquement programmable qui présente les caractéristiques de densité et vitesse élevée des mémoires bipolaires à accès aléatoire du type dynamique.

La mémoire morte électriquement programmable conforme à l'invention comprend des cellules (Cij) d'emmagasinage disposées en une matrice aux intersections de lignes de bits (BL) et de lignes de mots (WL) sur lesquelles l'application de potentiels appropriés provoque la sélection d'une cellule. Chaque cellule comporte un transistor bipolaire ayant une région de base connectée à une ligne de mots, une région collecteur et une région émetteur. Une couche diélectrique claquable est déposée au-dessus des régions émetteurs, la partie supérieure de ladite couche dans chaque cellule étant en contact avec la ligne de bits associée à la cellule. La mémoire comprend des moyens de programmation et de détection pour l'écriture et la lecture de cellules sélectionnées, lesdits moyens provoquant en mode de programmation la connexion de l'émetteur du transistor d'une cellule sélectionnée à la ligne de bit, la mémoire est caractérisée en ce que ladite couch diélectrique claquable est déposée sur une surface limitée à celle de ladite région émetteur, et en ce que les moyens de programmation et de détection comprennent:

un transistor (19) servant à la fois en mode programmation et pour la lecture des informations emmagasinées dans les cellules est associé à chaque ligne de bits, ledit transistor ayant son émetteur connecté à la ligne de bits, son collecteur étant connecté par l'intermédiaire d'au moins une résistance (23, 24) à une borne (25) pouvant recevoir un potentiel ayant une première valeur en mode programmation et une seconde valeur inférieure à la première en mode lecture et sa base pouvant recevoir un potentiel ayant une troisième valeur pour provoquer le claquage du diélectrique dans une cellule sélectionnée lorsque la ligne de mots associée est portée en mode programmation à un potentiel ayant une valeur voisine de la première,

et des moyens (15, BS, 17-1 à m) pour appliquer un potentiel ayant une valeur inférieure à la troisième valeur à l'émetteur du ou des transistors associés à ou aux lignes de bits connectées aux cellules sélectionnées en vue d'une opération d'écriture ou de lecture.

D'autres objets, caractéristiques et avantages de la présente invention ressortiront mieux de l'exposé qui suit, fait en référence aux dessins annexés à ce texte, qui représentent un mode de rélisation préféré de celle-ci.

Brève description des figures

La figure 1 représente le schéma électrique d'une cellule de mémoire avant programmation.

La figure 2 représente le schéma électrique de la même cellule de mémoire après programmation.

La figure 3 représente une couche de la densité de courant dans la cellule, dans l'un et l'autre de ses états.

La figure 4 représente schématiquement un arrangement de cellules pour constituer une mémoire morte électriquement programmable.

La figure 5 représente à titre d'exemple un décodeur d'adresses de lignes de mots qui peut être utilisé dans l'arrangement de la figure 4.

La figure 6 représente à titre d'exemple un décodeur d'adresses de lignes de bits qui peut être utilisé dans l'arrangement de la figure 4.

La figure 7 représente une vue de dessus de' deux cellules de mémoires intégrées avec les lignes de mots et de bits correspondantes.

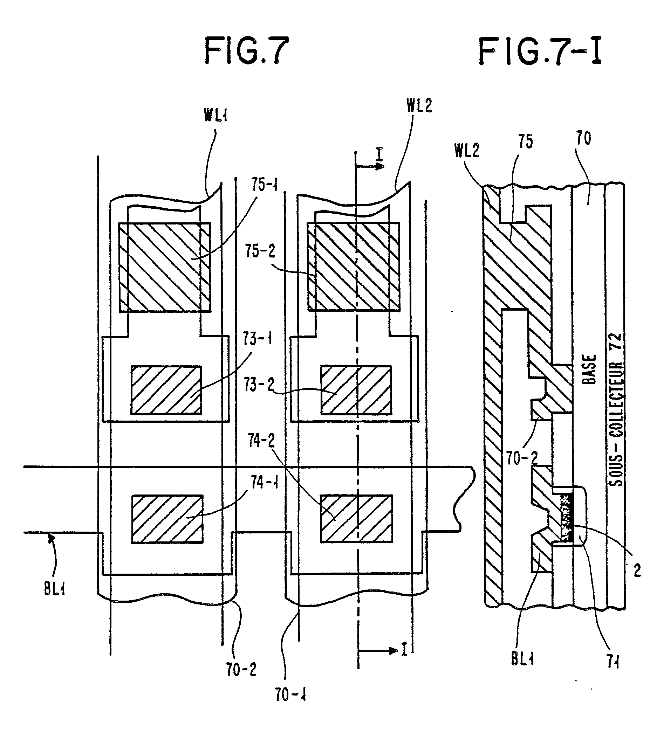

La figure 7-I représente une vue en coupe le long de la ligne I—I de la figure 7.

Description détaillée de la présente invention

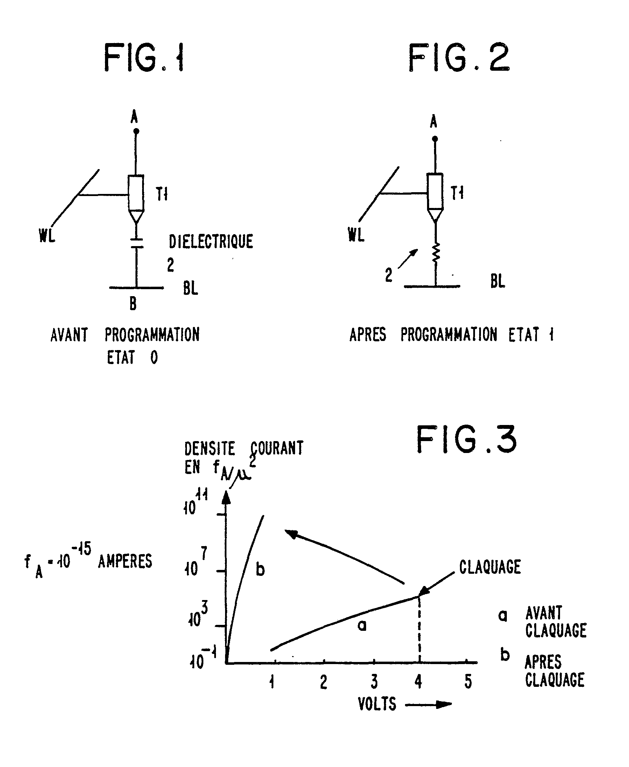

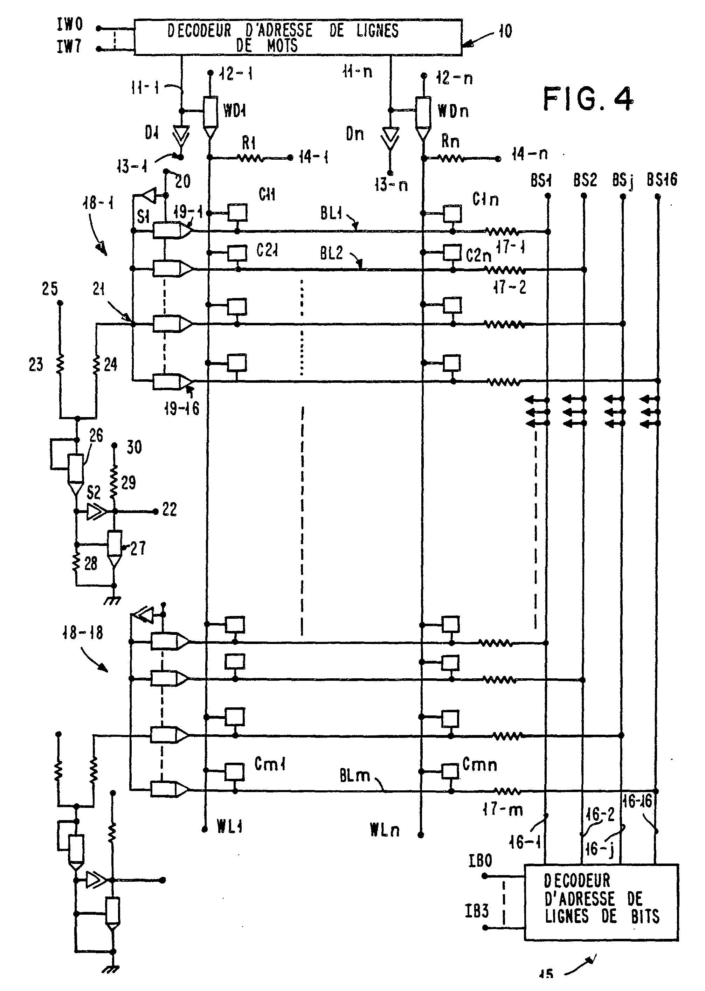

Le schéma électrique d'une cellule de mémoire est représenté sur la figure 1. Lorsque le réseau de mémoire est fabriqué chaque cellule comprend un transistor T1 qui dans un mode de réalisation préféré est un transistor NPN. Le collecteur de ce transistor est connecté à une tension de polarisation au point A. La base du transistor est connectée à une ligne de mot WL et l'émetteur, sur lequel est déposée une couche diélectrique représentée schématiquement en 2 par une capacité, est connecté à une ligne de bit BL au point B. La cellule dans cet état représente par exemple l'emmagasinage d'un 0 binaire. En conséquence l'utilisateur aura à sa disposition une mémoire morte constituée d'un réseau de cellules tel que représenté sur la figure 4, dans laquelle toutes les cellules emmagasinent un zéro.

Pour programmer la mémoire afin d'inscrire des uns dans les cellules désirées, on applique aux cellules sélectionnées des tensions appropriées, par l'intermédiaire des lignes de mots et des lignes de bits pour faire claquer le diélectrique. Dans ces conditions le diélectrique représenté en 2 devient un élément résistif provoquant un contact ohmique entre l'émetteur du transistor T1 et la ligne BL, comme représenté sur la figure 2.

Pour ce faire, le niveau sur la borne A est augmenté par rapport au niveau de fonctionnement normal. Dans un mode de réalisation préféré on le fait passer de 3,4 volts à 5 volts. Un niveau haut est appliqué sur la base du transistor et le niveau de la ligne de bit est abaissé pour qu'il y ait au moins une tension de 3,5 volts aux bornes de la couche diélectrique ce qui provoque son claquage.

Un moyen permettant de réaliser l'opération de programmation à l'état 1 des cellules désirées d'un ensemble de mémoire sera décrit en référence à la figure 4.

La figure 3 représente les courbes montrant les deux états d'une cellule.

La courbe *a* montre la densité du courant dans la cellule avant claquage du diélectrique, on peut voir que cette densité de courant est faible et que dans cet état la cellule est dans le même état qu'une cellule sans émetteur dans une mémoire morte classique personnalisable à la fabrication.

Le claquage se produit à au moins 3,5 volts et l'état de la cellule après claquage est représenté par la courbe *b*.

La tension de claquage doit être suffisamment faible pour assurer une compatibilité avec les circuits intégrés à densité élevée, c'est-à-dire quelques volts. Elle doit être aussi suffisamment contrôlée pour que la conception des circuits de programmation soit simple. Les autres caractéristiques électriques de la couche diélectrique peuvent être médiocres. Le courant de fuite d'un dispositif de 10 microns carré de surface peut être de l'ordre du microampère par volt dans l'état haute impédance (courbe *a*).

Des matériaux ayant une faible bande d'énergie 2 à 5 eV sont les plus appropriés puisqu'ils présentent une faible tension de claquage pour des épaisseurs qui sont suffisamment importantes pour être facilement contrôlables de l'ordre de $20 \times 10^{-6}$ à $100 \times 10^{-6}$ millimètres. Les diélectriques ayant des tensions de claquage de l'ordre de $10^5$ à $10^6$ volts par centimètre sont appropriés.

On peut donc utiliser:

1) des oxydes de métaux de transition ou des titanates tels que:

l'oxyde de tantale, l'oxyde de vanadium, l'oxyde de zirconium, l'oxyde de niobium, le titanate de baryum ou le titanate de strontium.

2) du silicium amorphe ou du silicium amorphe enrichi avec 1 ou 2% d'oxygène.

3) des matériaux déposés chimiquement sous faible pression, tels que l'oxyde de silicium $SiO_2$ ou l'alumine $Al_2O_3$, ou le nitrure de silicium $Si_3N_4$. Ces metériaux sont plus sensibles aux contraintes de tensions, et peuvent être utilisées en couches plus minces de l'ordre de $10 \times 10^{-6}$ millimètres. L'obtention de ces couches minces est cependant plus difficile à contrôler.

On va maintenant décrire en référence à la figure 4, un réseau de cellules de mémoire du type représenté sur la figure 1 avec les moyens permettant de réaliser la programmation de la mémoire, c'est-à-dire son chargement avec les données binaires appropriées, dans l'hypothèse où un 0 est représenté par l'état haute impédance et un 1 est représenté par l'état basse impédance. Bien entendu, on pourrait faire l'hypothése inverse sans sortir du cadre de ladite invention.

Les cellules C, cont disposées en $m$ rangées et $n$ colonnes. Les cellules sont disposées aux intersections de $n$ lignes de mots WL1 à WLn, deux de ces lignes sont représentées et de $m$ lignes de bits BL1 à BLm. Une cellule à l'intersection de la ligne de mots WLi et de la ligne de bits BLk porte la référence CiK. Seules certaines cllules portent cette notation sur le dessin pour plus de clarté. On peut faire un réseau comportant au moins 288 lignes de bits et 256 lignes de mots.

Les bases de transistors des cellules de chaque colonne sont connectées à une ligne de mots, les bases des cellules de la première colonne sont connectées à la ligne de mots WL1 et les bases des cellules de la dernière colonne $n$ sont connectées à la ligne WLn. Les lignes de mots intermédiaires ne sont pas représentées pour plus de clarté.

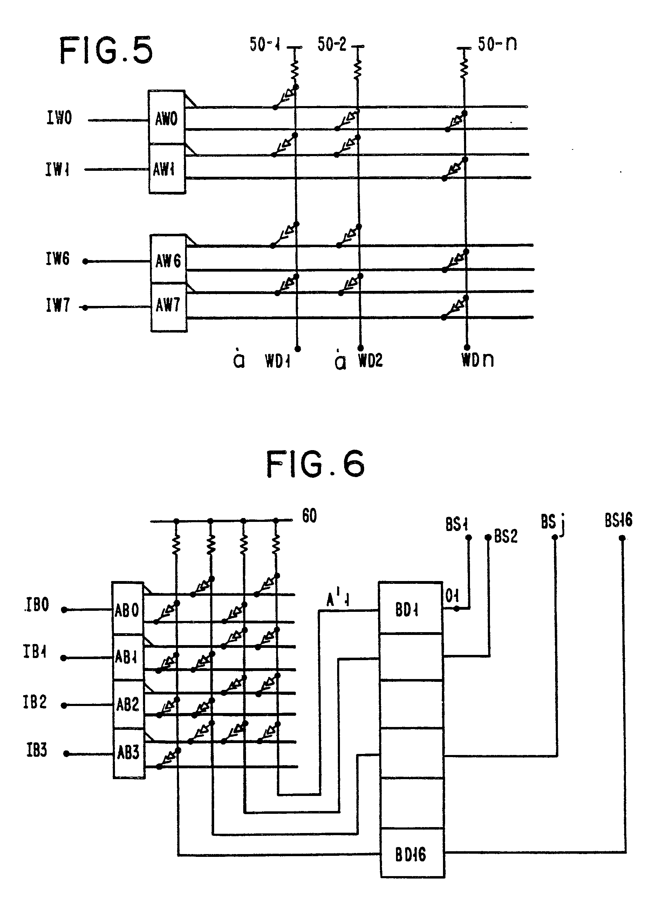

Les lignes de mots sont adressées par un décodeur d'adresses de lignes de mots 10. Les circuits pouvant être utilisés pour réaliser cette fonction sont bien connus, un exemple de réalisation est représenté sur la figure 5.

Le circuit décodeur d'adresse reçoit les signaux d'adressage, huit sont représentés sur la figure, IW0 à IW7, ils permettent d'adresser $2^8$ lignes de mots soit 256. Les sorties du décodeur d'adresse 11-1 à 11-n sont appliquées aux bases des transistors d'attaque de lignes de mots WD1 à WDn. Les lignes de mots sont connectées aux émetteurs des transistors d'attaque. Pour sélectionner une ligne de mots, le décodeur d'adresse engendre sur la sortie correspondante un signal qui rend conducteur le transistor d'attaque associé à cette ligne, les transistors d'attaque associés aux lignes non sélectionnées étant bloqués.

Les collecteurs des transistors d'attaque sont connectés à des bornes 12-1 à 12-n respectivement sur lesquelles peuvent être appliquées des tensions de polarisation appropriées. Les bases des transistors d'attaque sont connectées aux anodes de diodes de Schottky D1 à Dn dont les cathodes sont connectées à des bornes 13-1 à 13-n respectivement, sur lesquelles peuvent être appliquées des tensions appropriées d'une façon qui sera décrite ultérieurement. Les émetteurs des transistors d'attaque sont connectés par des résistances R1 à Rn à des bornes 14-1 à 14-n.

Les points B des cellules d'une même rangée sont connectés à une ligne de bit BL. Les $m$ lignes de bits BL1 à BLm sont réparties en $k$ groupes comprenant m/k lignes. Dans le mode de réalisation où $m$ égal 288, on choisit k=16, les lignes de bits sont donc réparties en 16 groupes de 18 lignes, ce qui permet d'adresser simultanément les 18 lignes de bits d'un mot. Chaque groupe est adressé par 16 lignes BS1 à BS16. Chacune des lignes BS1 à BS16 est connectée à 18 lignes de bits, comme représenté schématiquement sur la figure. Cette disposition qui est déjà connue ne fait pas partie de l'invention. Ce mode de réalisation n'est choisi qu'à titre d'exemple.

Les lignes BS1 à BS16 sont sélectionnées par un décodeur d'adresse de lignes de bits 15 qui à partir de quatre signaux d'adresses IB0 à IB3, engendre un signal de sélection approprié sur les sorties 16-1 à 16-n pour sélectionner une des lignes BS1 à BS16. Un circuit qui peut être utilisé pour mettre en oeuvre cette fonction est représenté sur la figure 6.

Les lignes de bits sont connectées aux lignes BS1 à BS16 par des résistances 17-1 à 17-m d'une part et à 18 circuits de détection et de programmation 18-1 à 18-18 d'autre part.

On n'a représenté sur le dessin que deux circuits de détection et de programmation 18-1 à 18-18. Ces ciruits étant identiques ou n'en décrira qu'un seul, le circuit 18-1.

Le circuit 18-1 comporte 16 transistors 19-1 à 19-16 dont les émetteurs sont connectés aux lignes de bits sélectionnées par les lignes BS1 à BS16. Les bases des transistors 19-1 à 19-16 sont reliées ensemble à la borne 20, il en est de même pour leurs collecteurs qui sont connectés au noeud commun 21. Une diode de Schottky d'antisaturation S1 a son anode connectée à la borne 20 et sa cathode connectée au point 21.

La borne 20 est connectée à une tension de polarisation appropriée dans le mode de lecture de la mémoire et à une tension de programmation pour réaliser le chargement des cellules.

Les bits de données lus sont fournis à la sortie d'un circuit de lecture. Ce circuit comprend les résistances 23 et 24 ayant une borne commune, l'autre borne de la résistance 24 éant reliée au point 21 et l'autre borne de la résistance 23 est connectée à une borne 25, sur laquelle est appliquée une tension appropriée en mode de lecture et en mode programmation.

Le point commun des résistances 23 et 24 est connecté au collecteur d'un transistor 26 monté en diode. L'émetteur du transistor 26 est connecté à la base d'un transistor 27 polarisé par une résistance 28 disposée entre la base du transistor 27 et la masse.

L'émetteur du transistor 27 est aussi connecté à la masse, son collecteur est connecté par une résistance 29 à une borne 30 sur laquelle est appliquée une tension différente en mode lecture et en mode programmation. Une diode de Schottky d'antisaturation S2 est disposée entre le collecteur et la base du transistor 27.

Les valeurs des différentes tensions appliquées sur les différentes bornes sont les suivantes dans un mode de réalisation préféré, il est bein entendu que d'autres valeurs peuvent être choisies pour autant qu'elles permettent de réaliser l'opération de claquage du matériau diélectrique.

| Bornes | Mode Lecture | Mode programmation |
|---|---|---|
| 12-1 à 12-n | +3,4 V | +p5 V |
| 13-1 à 13-n | +2,05 V | +5 V |
| 14-1 à 14-n | +1,0 V | +1,0 V |
| 20 | 1,4 V | +5 V pour 0<br>+0,8 V pour 1 |
| 25 | +3,4 V | +5 V |
| 30 | 1,7 V | +5 V |

On va maintenant décrire le fonctionnement d'un tel ensemble. A la fabrication toutes les cellules sont constituées comme sur la figure 1, et sont donc supposées dans l'état zéro.

Pour programmer un 1 dans une cellule sélectionnée c'est-à-dire claquer le diélectrique, les bornes 12-1 à 12-n et 13-1 à 13-n sont mises à la valeur haute +5 volts. On va supposer que l'on veuille sélectionner la cellule C11, pour cela, la ligne de mots WL1 est sélectionnée, de ce fait la tension sur la base du transistor de la cellule C11 est légèrement inférieure à +5 volts. La ligne de bit BL1 est sélectionnée en abaissant le potentiel sur la ligne BS1.

La borne 20 est mise à 0,8 volt et la tension aux bornes de la couche diélectrique est de l'ordre de 4,2 volts. En appliquant sur la borne 20 une tension de 5 volts, la couche diélectrique n'est pas claquée. Les bornes 25 et 30 sont mises à 5 volts dans le mode programmation pour assurer la protection des transistors.

En mode lecture, l'ensemble fonctionne de la même façon qu'une mémoire à personnalisation par mise en place ou non des émetteures des transistors des cellules, c'est-à-dire que pour lire l'état des 18 cellules addressées par une des lignes BS1 à BS16 connectées à une ligne de mots, la ligne de mots est sélectionnée de même que la ligne BSj désirée, et les circuits 18-1 à 18-18 fournissent sur les sorties 22 une information binaire correspondant à l'état des cellules adressées. Cette opération qui est classique ne sera pas décrite plus en détail.

Les figures 5 et 6 représentent deux circuits décodeurs qui peuvent être utilisés comme circuits 10 et 15 respectivement.

Le circuit de la figure 5 comprend huit générateurs de valeur vraie/complémentaire AW0 à AW7 qui reçoivent sur leurs entrées les bits d'adresse IW0 à IW7. Ils fournissent sur leurs sorties indiquée par le signe △, la valeur complémentaire du signal d'entrée et sur l'autre sortie, la valeur vraie dudit signal. Le décodeur proprement dit est constitué par une matrice de diodes de Schottky. Chaque ligne verticale de la matrice est connectée à la base d'un transistor d'attaque WD1 à WDn et les lignes horizontales sont constituées par les lignes de sortie des générateurs AW0 à AW7. Les anodes des diodes sont connectées aux lignes verticales et les cathodes à des lignes horizontales, de telle façon que lorsqu'un signal d'adressage d'une ligne de mot, par exemple 00000000 pour la ligne WL1, les diodes correspondantes soient toutes bloquées pour qu'un signal de viveau haut égal à la tension à la borne 50-1 soit appliqué à la base du transistor WD1. Dans le mode programmation, cette tension est de 5 volts et dans le mode lecture normale elle est de 3,4 volts.

Le décodeur d'adresse de lignes de bits est réalisé de la même façon sauf qu'il ne comporte que 4 générateurs de valeur vraie/complémentaire AB0 à AB3 qui reçoivent les bits des signaux d'adressage IB0 à IB3, puisqu'il ne faut sélectionner qu'une parmi les seize lignes BS1 à BS16. Des circuits d'attaque BD1 à BD16 permettent d'imposer sur la ligne sélectionnée BS1 à BS16 un niveau bas.

On va maintenant décrire en référence aux figures 7 et 7-I la disposition dans le silicium de deux cellules par exemple C11 et C12 connectées aux lignes de mots WL1 et WL2 (non représentées sur la figure 4) et à la ligne de bits BL1.

La ligne de bits BL1 est située au premier niveau de métal et les lignes de mots WL1 et WL2 sont reliées au deuxième niveau de métal comme on peut le voir sur la vue en coupe 7-I, les deux niveaux étant séparés par un isolant. Les transistors des cellules sont intégrés dans une couche dopée P 70, constituant la base. Sur la figure 7, cette couche est référencée par 70-1 et 70-2. Une région N+ d'émetteur 71 est prévue au-dessus de laquelle est disposée la couche diélectrique 2. La région 72 constitue le sous-collecteur du transistor.

Sur la vue de dessus, on peut voir en 73-1 et 73-2 les contacts à la base et en 74-1 et 74-2 les ouvertures à l'émetteur.

Les lignes de nots WL1 et WL2 sont connectées aux bases des transistors par un "via" 75-1 et 75-2.

Le contact collecteur des transistors n'est pas représenté sur cette figure. Etant donné que les collecteurs de plusieurs transistors doivent être connectés à une même tension, il peut y avoir un contact commun à plusieurs transistors, situé à un point approprié dans l'ensemble. Cette disposition qui est classique ne sera pas décrite plus en détail.

Ces figures 7 et 7-I montrent donc que l'ensemble de mémoire peut être très dense puisque la couche diélectrique n'occupe pas de surface supplémentaire sur le silicium.

Bien que l'ensemble de mémoire ait été décrit comme composé de cellules comprenant un transistor NPN, il est bien entendu que l'on peut utiliser un transistor d'un autre type par exemple PNP sans pour autant sortir du cadre de ladite invention. Dans cette hypothèse, il conviendra simplement de changer les tensions de commande, ce qui est évident pour l'homme de l'art.

## Revendications

1. Mémoire morte électriquement programmable comprenant des cellules (Cij) d'emmagasinage disposées en une matrice aux intersections de lignes de bits (BL) et de lignes de mots (WL) sur lesquelles l'application de potentiels appropriés provoque la sélection d'une cellule, chaque cellule comportant un transistor (T1) bipolaire ayant une région de base (70) connectée à une ligne de mots, une région collecteur (72) et une région émetteur (71), une couche diélectrique claquable (2) déposée au-dessus des régions émetteurs, la partie supérieure de ladite couche dans chaque cellule étant en contact avec la ligne de bit associée à la cellule, la mémoire comprenant des moyens de programmation et de détection pour l'écriture et la lecture de cellules sélectionnées, lesdits moyens provoquant en mode de programmation la connexion de l'émetteur du transistor d'une cellule sélectionnée à la ligne de bit et étant caractérisée en ce que:

ladite couche diélectrique claquable est déposée sur une surface limitée à celle de ladite région émetteur, et en ce que:

les moyens de programmation et de détection comprennent:

un transistor (19) servant à la fois en mode programmation et pour la lecture des informations emmagasinées dans les cellules est associé à chaque ligne de bits, ledit transistor ayant son émetteur connecté à la ligne de bits, son collecteur étant connecté par l'intermédiaire d'au moins une résistance (23, 24) à une borne (25) pouvant recevoir un potentiel ayant une première valeur en mode programmation et une seconde valeur inférieure à la première en mode lecture et sa base pouvant recevoir un potentiel ayant une troisième valeur pour provoquer le claquage du diélectrique dans une cellue sélectionnée lorsque la ligne de mots associée est portée en mode programmation à un potentiel ayant une valeur voisine de la première,

et des moyens (15, BS, 17-1 à m) pour appliquer un potentiel ayant une valeur inférieure à la troisième valeur, à l'émetteur du ou des transistors associés à ou aux lignes de bits connectées aux cellules sélectionnées en vue d'une opération de programmation ou de lecture.

2. Mémoire morte selon la revendication 1 caractérisée en ce que la couche diélectrique est constituée d'un matériau du groupe des oxydes des métaux de transition.

3. Mémoire morte selon la revendication 1 caractérisée en ce que la couche diélectrique est constituée par le titanate de baryum.

4. Mémoire morte selon la revendication 1 caractérisée en ce que la couche diélectrique est constituée par le titanate de strontium.

5. Mémoire morte selon la revendication 1 caractérisée en ce que la couche diélectrique est un silicium amorphe.

6. Mémoire morte selon la revendication 5 caractérisée en ce que le silicium amorphe est enrichi avec 1 à 2% d'oxygène.

7. Mémoire selon l'une quelconque des revendications précédentes caractérisée en ce que la couche diélectrique a une épaisseur comprise entre $20 \times 10^{-6}$ et $100 \times 100^{-6}$ millimètres.

8. Mémoire morte selon l'une quelconque des revendications précédentes caractérisée en ce que la première valeur est égale à 5 volts, la seconde est égale à 3,4 volts et la troisième est égale à 0,8 volts.

## Patentansprüche

1. Elektrisch programmierbarer Festwertspeicher mit Speicherzellen (Cij), die in einer Matrix an den Schnittstellen der Bit-Linien (BL) mit den Wortlinien (WL) angeordnet sind, wobei das Anlegen geeigneter Spannungspegel an den Schnittstellen die Wahl einer Zelle bewirkt, jede Zelle einen bipolaren Transistor (T1) umfasst mit einer an einer Wortlinie angeschlossenen Basiszone (70), einer Kollektorzone (72) und einer Emitterzone (71), einer über den Emitterzonen aufgetragenen, durchschlagbaren Sperrschicht (2), deren Oberteil in jeder Zelle im Kontakt mit der zur Zelle gehörenden Bitlinie steht, der Speicher Programmier- und Detektiermittel zum Schreiben und Lesen gewählter Zellen besitzt, die genannten Mittel in Programmier-Betriebsart die Verbindung des Transistor - Emitters einer gewählten Zelle mit der Bit-linie herstellen und die Vorrichtung dadurch gekennzeichnet ist, dass:

die genannte durchchlagbare Sperrschicht auf einer Zone aufgetragen ist, die auf die genannte Emitterzone begrenzt ist, und dass:

die Programmier- und Detektiermittel folgendes umfassen:

einen zu jeder Bit-Linie gehörenden Transistor (19), der gleichzeitig für die Programmier - Betriebsart und zum Lesen der in den Zellen gespeicherten Informationen dient, wobei sein Emitter mit der Bit-Linie verbunden ist, sein Kollektor über zumindest einen Widerstand (23, 24) an einer Klemme (25) angeschlossen ist, die eine Spannung mit einem ersten Wert in Programmier - Betriebsart und eine zweite geringere Spannung in Lese-Betriebsart erhalten kann, und dessen Base eine Spannung mit einem dritten Wert empfangen kann, um ein Durchschlagen der Sperrschicht in einer gewählten Zelle zu bewirken, wenn die dazugehörige Wort-Linie in Programmier - Betriebsart auf eine Spannung gebracht wird, deren Wert in der Nähe der vorgennanten Spannung liegt.

und Mittel (15, BS, 17-1 bis m), um eine Spannung mit einem Wert unter dem der dritten Spannung am Emitter des oder der zu den Bit-Linien gehörenden Transistoren anzulegen, die im Hinblick auf einen Programmier- oder Lesevorgang mit den gewählten Zellen verbunden sind.

2. Festwertspeicher nach Anspruch 1, dadurch gekennzeichnet, dass die Sperrschicht aus einem Werkstoff der Oxidgruppe der Transitionsmetalle besteht.

3. Festwertspeicher nach Anspruch 1, dadurch gekennzeichnet, dass die Sperrschicht aus Bariumtitanat besteht.

4. Festwertspeicher nach Anspruch 1, dadurch gekennzeichnet, dass die Sperrschicht aus Strontiumtitanat besteht.

5. Festwertspeicher nach Anspruch 1, dadurch gekennzeichnet, dass die Sperrschicht aus amorphem Silizium besteht.

6. Festwertspeicher nach Anspruch 5, dadurch gekennzeichnet, dass das amorphe Silizium mit 1 bis 2% Sauerstoff angereichert ist.

7. Speicher nach einem beliebigen der vorstehenden Ansprüche, dadurch gekennzeichnet, dass die Sperrschicht eine Stärke zwischen $20 \times 10^{-6}$ und $100 \times 10^{-6}$ Millimeter besitzt.

8. Festwertspeicher nach einem beliebigen der vorstehenden Ansprüche, dadurch gekennzeichnet, dass der erste Wert gleich 5 Volt, der zweite gleich 3,4 Volt und der dritte gleich 0,8 Volt ist.

**Claims**

1. An electrically programmable read only memory comprising memory cells (Cij) located at the intersections of the bit lines (BL) and word lines (WL) of a matrix which, when submitted to the application of appropriate potentials, cause a cell to be selected, each cell including a bipolar transistor (T1) having a base region (70) connected to a word line, a collector region (72) and an emitter region (71), a dielectric layer (2) which can be broken down and deposited on the emitter regions, the upper portion of said layer in each cell being in contact with the bit line associated with the cell, the memory including programming and detecting means for writting and reading selected cells, said means in the programming mode causing a selected cell transistor emitter to be connected to the bit line and being characterized in that:

said dielectric layer which can be broken down is deposited over a surface restricted to the one of said emitter region, and in that:

the programming and detecting means comprise:

a transistor (19) used in programming mode and also for reading information stored in the cells, is associated to each bit line, said transistor having it emitter connected to the bit line, its collector being connected through at least a resistor (23, 24) to a terminal (25) able to receive a potentiel having a first value in programming mode and a second value smaller than the first one, in reading mode and its base being able to receive a potential having a third value to cause the dielectric layer to break down in a selected cell when the associated word line is brought in programming mode, to a potential having a value close to the first one,

and means (15, BS, 17-1 to m) for applying a potential having a value smaller than the third value, to the emitter of the transistor(s) associated to the bit line(s) connected to the selected cells with a view to a programming or reading operation.

2. The read only memory in accordance with claim 1 characterized in that the dielectric layer is comprised of a material selected from the transition metal oxide group.

3. The read only memory in accordance with claim 1 characterized in that the dielectric layer is comprised of barium titanate.

4. The read only memory in accordance with claim 1 characterized in that the dielectric layer is comprised of strontium titanate.

5. The read only memory in accordance with claim 1 characterized in that the dielectric layer is comprised of amorphous silicon.

6. The read only memory in accordance with claim 5 characterized in that said amorphous silicon is enriched with 1 to 2% of oxygen.

7. The read only memory in accordance with any one of the above claims characterized in that the dielectric layer has a thickness of between $20 \times 10^{-6}$ and $100 \times 10^{-6}$ mm.

8. The read only memory in accordance with any one of the above claims characterized in that the first value is of 5 volts, the second value is of 3.4 volts and the third value is of 0.8 volts.

# FIG.1

A

T1

WL

DIELECTRIQUE

2

BL

B

AVANT PROGRAMMATION
ETAT 0

# FIG.2

A

T1

WL

2

BL

APRES PROGRAMMATION ETAT 1

# FIG.3

DENSITE COURANT
EN $fA/\mu^2$

$fA = 10^{-15}$ AMPERES

$10^{11}$

$10^7$

b

$10^3$

$10^{-1}$

CLAQUAGE

a

1   2   3   4   5

VOLTS →

a   AVANT
    CLAQUAGE

b   APRES
    CLAQUAGE

FIG. 4

# FIG.5

# FIG.6

# FIG.7

# FIG.7-I